# FASCICULE DE BREVET EUROPEEN

(11) **EP 0 921 405 B1**
(45) Date de publication et mention de la délivrance du brevet: **20.10.2004**
(21) Numéro de dépôt: 98403055.1
(22) Date de dépôt: 04.12.1998
(51) Int. Cl.: G01R 31/02

(54) **Procédé de détection directionnelle de défaut sur un réseau de distribution d'énergie électrique**
Verfahren zur Bestimmung der Richtung eines Fehlers auf einem Leistungsübertragungsnetz
Method for directional detection of a fault on an electric power distribution unit

(30) Priorité: 08.12.1997 FR 9715494
(43) Date de publication de la demande: 09.06.1999
(73) Titulaire: Manufacture D'Appareillage Electrique de Cahors - MAEC, 46000 Cahors (FR)
(72) Inventeur: Grandjean, Hervé, 46090 Espere (FR)
(74) Mandataire: Keib, Gérard

(56) Documents cités:
- EP-A- 0 573 333
- FR-A- 2 326 065

## Description

La présente invention concerne un procédé et un dispositif de détection de défaut sur une ligne d'un réseau de distribution d'énergie électrique, ladite détection étant basée sur la comparaison des signes respectifs des variations transitoires des courants homopolaires et des variations transitoires des tensions homopolaires de la ligne à surveiller.

Les procédés de détection de défauts connus dans l'art antérieur utilisent un principe de détection "ampéremètrique" pour détecter des défauts polyphasés, ou un principe de détection directionnelle, nécessitant la mesure du courant et de la tension homopolaire, pour détecter des défauts à la terre. Ces procédés utilisent soit des détecteurs souterrains installés en cabine dans des postes de transformation HTA/BT par exemple, soit des détecteurs aériens, dits de " proximité installés dans un coffret en pied de poteau support de ligne HTA. Dans le premier cas, la mesure du courant est faite généralement par des tores placés sur chacune des phases, tandis que la mesure de la tension est faite généralement par des diviseurs capacitifs, tandis que dans le deuxième cas la mesure du courant est faite par un capteur de champ magnétique et la mesure de la tension est faite par un capteur de champ électrique.

Un example d'un procédé de détection des défauts à la terre d'un réseau de distribution d'énergie est décrit dans EP A 0573 333.

Le principe de la détection directionnelle de défaut monophasé à la terre est basé sur l'analyse des phénomènes transitoires en courant et en tension des grandeurs homopolaires mesurées par les capteurs.

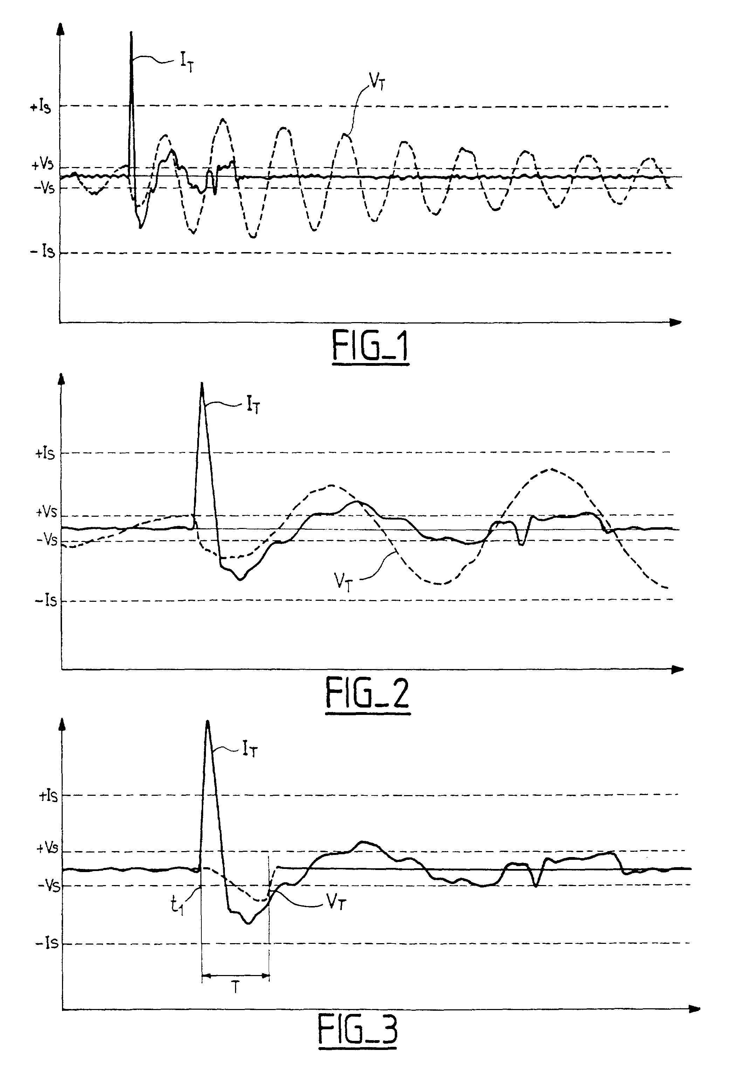

En l'absence de défaut, le capteur de champ électrique récupère une tension de bruit, variant à une fréquence de 50Hz environ, due au déséquilibre naturel du réseau. Comme on peut le voir sur les figures 1 et 2, lorsque le transitoire de tension homopolaire provoqué par le défaut survient, il se superpose à ladite tension de bruit. De ce fait, le signe de la tension homopolaire détectée par le capteur au moment de l'apparition du transitoire de tension est totalement aléatoire en raison de l'absence de synchronisme entre ce transitoire de tension et le signal de bruit. En outre, l'élimination de ce signal de bruit s'avère très difficile du fait que le transitoire de tension varie également une fréquence proche de 50 Hz.

Le but de l'invention est de concevoir un procédé de détection de défaut sur une ligne HTA permettant d'éliminer le signal de bruit pendant la détection du transitoire de tension provoqué par un défaut sur ladite ligne de manière à déterminer, sans ambiguïté, le signe dudit transitoire de tension dès son apparition.

Selon l'invention, on détecte le premier dépassement par le transitoire de courant d'un seuil minimal de courant prédéterminé, ce premier dépassement déclenche une temporisation d'une durée prédéterminée pendant laquelle on observe le premier dépassement par le transitoire de tension d'un seuil de tension minimal prédéterminé, ladite durée étant sensiblement égale à la durée maximale dudit transitoire de tension, puis, l'on compare, pendant cette durée, le signe du transitoire de courant avec le signe de transitoire de tension.

Selon une autre caractéristique de l'invention, en dehors de ladite durée d'observation, on bloque le niveau de la tension homopolaire à une valeur nulle de manière à observer la variation transitoire de ladite tension homopolaire par rapport à un niveau de référence exempt de bruit.

Ainsi, on détermine sans ambiguïté le signe du signal transitoire de tension dès son apparition dans la mesure où les variations de ce dernier se font autour d'une valeur de référence égale à zéro.

D'autres caractéristiques et avantages de l'invention ressortiront de la description qui va suivre, prise à titre d'exemple non limitatif, en référence aux figures annexées dans lesquelles:
- la figure 1 représente, sur un même graphique, des courbes des variations du courant homopolaire et de la tension homopolaire d'une ligne HTA;
- la figure 2 illustre une vue agrandie de la figure 2;
- la figure 3 représente sur un même graphique, des courbes de variations du courant homopolaire et de la tension homopolaire d'une ligne HTA analysés par un procédé conforme à l'invention;
- la figure 4 représente un organigramme illustrant un procédé conforme à l'invention;
- la figure 5 représente un schéma synoptique d'un dispositif mettant en oeuvre un procédé conforme à l'invention.

La figure 3 illustre les variations transitoires du courant homopolaire I et les variations transitoires de la tension homopolaire V d'une ligne HTA d'un réseau de distribution d'énergie. Ces variations sont détectées par un procédé basé sur la comparaison des signes respectifs des variations transitoires des courants homopolaires et des variations transitoires des tensions homopolaires de la ligne à surveiller. Ce procédé est caractérisé en ce que l'on détecte le premier dépassement, positif ou négatif, par le transitoire de courant I_{T}, d'un seuil minimal de courant prédéterminé de valeur positive +I_{S} et de valeur négative -I_{S}. Ce dépassement se produit à l'instant t₁ et déclenche une temporisation d'une durée T prédéterminée pendant laquelle on observe le premier dépassement, positif ou négatif, par le transitoire de tension V_{T}, d'un seuil minimal de tension prédéterminé de valeur positive +V_{S} et de valeur négative -V_{S}, ladite durée T étant sensiblement égale à la durée maximale dudit transitoire de tension. Ensuite, on compare, pendant cette durée T, le signe du transitoire de courant I_{T} avec le signe du transitoire de tension V_{T} afin de déterminer la direction du défaut.

Comme on peut le voir sur la figure 3, en dehors de ladite durée T d'observation, on bloque, par un filtrage approprié, le niveau de la tension homopolaire à une valeur nulle de manière à observer la variation transitoire de ladite tension par rapport à un niveau de référence exempt de bruit. Le signal transitoire de tension est alors extrait par dérivation et intégration successives afin d'être exploité par un dispositif électronique de traitement relié aux capteurs.

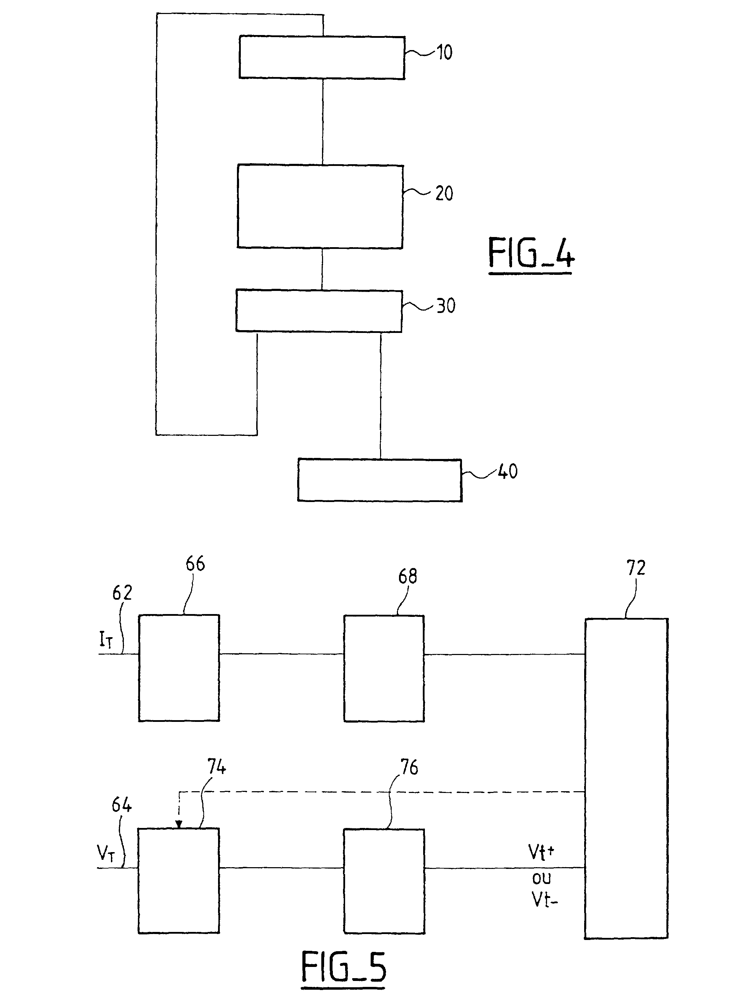

La figure 4 représente un organigramme illustrant les différentes étapes du procédé selon l'invention. Comme on peut le voir sur cette figure, le procédé comporte une première étape 10 de surveillance du courant homopolaire de la ligne HTA. Cette étape 10 et suivie par une étape 20 au cours de laquelle une fenêtre temporelle d'observation de la tension homopolaire est ouverte lorsqu'un transitoire de courant dépasse le seuil I_{S} pour la première fois. Pendant cette durée d'observation T, le dispositif électronique de traitement détecte le premier dépassement du seuil V_{S} par le transitoire de tension V_{T} et analyse le signe de ce dépassement au cours d'une troisième étape 30. Ensuite, ledit dispositif de traitement compare les signes respectifs du premier dépassement de I_{S} par le transitoire de courant I_{T} et du premier dépassement de V_{S} par le transitoire de tension V_{T} pour déduire, à l'étape 40, le sens de la direction du défaut.

Comme cela a été dit précédemment, la durée T de la fenêtre d'observation est prédéterminée et est égale à la durée maximale du transitoire de tension.

La figure 5 représente un schéma synoptique d'un dispositif électronique de traitement permettant de mettre en oeuvre le procédé conforme à l'invention.

Ce dispositif comporte une première chaîne 62 de traitement du courant homopolaire fonctionnant en parallèle avec une deuxième chaîne 64 de traitement de la tension homopolaire. La première chaîne 62 comporte un premier étage 66 de filtrage et d'amplification du courant homopolaire I_{T} dont la sortie est reliée à l'entrée d'un premier étage comparateur 68 destiné à détecter le premier dépassement du seuil de courant et le signe de ce dépassement. La sortie du premier étage comparateur 68 est reliée à un bloc de calcul 72.

La deuxième chaîne 64 de traitement de la tension homopolaire V_{T} comporte un deuxième étage 74 de filtrage et d'amplification de la tension homopolaire dont la sortie est reliée à l'entrée d'un deuxième étage comparateur 76 destiné à détecter le premier dépassement du seuil de tension et le signe de ce dépassement. La sortie du deuxième étage comparateur 78 est reliée au bloc de calcul 72. Ce dernier compare, pendant la durée T, les signes respectifs du premier dépassement du seuil de courant I_{S} par le transitoire de courant I_{T} avec le courant I_{T} avec le premier dépassement du seuil de tension V_{S} par le transitoire de tension V_{T} et détermine la direction du défaut sur la ligne HTA.

## Revendications

1. Procédé de détection de défaut sur une ligne d'un réseau de distribution d'énergie électrique basé sur la comparaison des signes respectifs des variations transitoires des courants homopolaires et des variations transitoires des tensions homopolaires de la ligne à surveiller,
**caractérisé en ce que** l'on détecte le premier dépassement par le transitoire de courant d'un seuil minimal de courant prédéterminé, ledit dépassement déclenche une temporisation d'une durée prédéterminée pendant laquelle on observe le premier dépassement par le transitoire de tension d'un seuil de tension minimal prédéterminé, ladite durée étant sensiblement égale à la durée maximale dudit transitoire de tension, puis, l'on compare, pendant cette durée, le signe du transitoire de courant avec le signe de transitoire de tension.

2. Procédé selon la revendication 1,
**caractérisé en ce que**, en dehors de ladite durée d'observation, on bloque le niveau de la tension homopolaire à une valeur nulle de manière à observer la variation du transitoire de tension par rapport à un niveau de référence exempt de bruit.

3. Dispositif électronique de détection de défaut sur une ligne d'un réseau de distribution d'énergie électrique, sur la base d'une comparaison des signes respectifs de variations transitoires de courants homopolaires et de variations transitoires de tensions homopolaires de la ligne à surveiller,
**caractérisé en ce qu'**il comprend des moyens (68) pour détecter un premier dépassement par le transitoire de courant d'un seuil minimal de courant prédéterminé, des moyens pour déclencher, à la suite de la détection du premier dépassement, une temporisation d'une durée prédéterminée, des moyens (76) pour détecter, pendant que la temporisation est déclenchée, un premier dépassement par le transitoire de tension d'un seuil de tension minimal prédéterminé, ladite durée étant sensiblement égale à la durée maximale dudit transitoire de tension, et des moyens (72) pour comparer, pendant ladite durée, le signe du transitoire de courant avec le signe de transitoire de tension.

4. Dispositif selon la revendication 3,
**caractérisé en ce qu'**il comporte une première chaîne (62) de traitement du courant homopolaire comportant un premier étage (66) de filtrage et d'amplification du courant homopolaire (I_{T}) dont la sortie est reliée à l'entrée d'un premier étage comparateur (68) destiné à détecter le premier dépassement du seuil de courant et le signe de ce dépassement et dont la sortie est reliée à un bloc de calcul (72).

5. Dispositif selon la revendication 4,
**caractérisé en ce qu'**il comporte en outre une deuxième chaîne (64) de traitement de la tension homopolaire, fonctionnant en parallèle avec la première chaîne (62) de traitement du courant homopolaire et comportant un deuxième étage (74) de filtrage et d'amplification de la tension homopolaire dont la sortie est reliée à l'entrée d'un deuxième étage comparateur (76) destiné à détecter le premier dépassement du seuil de tension et le signe de ce dépassement et dont la sortie est reliée au bloc de calcul (72).

6. Dispositif selon la revendication 5,
**caractérisé en ce que** le bloc de calcul (72) compare, pendant la durée du transitoire de tension, le signe du premier dépassement du seuil de courant par le transitoire de courant avec le signe du premier dépassement du seuil de tension par le transitoire de tension et détermine la direction du défaut sur la ligne d'un réseau de distribution d'énergie électrique.

## Patentansprüche

1. Verfahren zur Fehlererkennung auf einer Leitung eines elektrischen Energieverteilungsnetzes, basierend auf dem Vergleich jeweiliger Vorzeichen von Einschwingvorgängen gleichpoliger Ströme und von Einschwingvorgängen gleichpoliger Spannungen der zu überwachenden Leitung, **dadurch gekennzeichnet, dass** das erste Überschreiten einer vorbestimmten minimalen Stromschwelle durch den Einschwingstrom erfasst wird, wobei das Überschreiten eine Verzögerung einer vorbestimmten Zeitdauer auslöst, während der das erste Überschreiten einer vorbestimmten minimalen Spannungsschwelle durch die Einschwingspannung beobachtet wird, wobei die Zeitdauer im Wesentlichen gleich ist der maximalen Zeitdauer der Einschwingspannung, und dann während dieser Zeitdauer das Vorzeichen des Einschwingstroms mit dem Vorzeichen der Übergangsspannung verglichen wird.

2. Verfahren nach Anspruch 1,
**dadurch gekennzeichnet, dass** außerhalb der Beobachtungsdauer die Höhe der homopolaren Spannung auf einen Nullwert geklemmt wird, um die Schwankung der Übergangsspannung in Bezug auf einen Referenzwert, abgesehen von Rauschen, zu beobachten.

3. Elektronische Vorrichtung zur Fehlererkennung auf einer Leitung eines elektrischen Energieverteilungsnetzes basierend auf dem Vergleich jeweiliger Vorzeichen von Einschwingvorgängen gleichpoliger Ströme und von Einschwingvorgängen gleichpoliger Spannungen der zu überwachenden Leitung, **dadurch gekennzeichnet, dass** sie Mittel (68) zum Erkennen eines ersten Überschreitens einer vorbestimmten minimalen Stromschwelle durch den Einschwingstrom, Mittel zum Auslösen, nach der Erfassung des ersten Überschreitens, einer Verzögerung einer vorbestimmten Zeitdauer, Mittel (76) zum Erfassen, während die Verzögerung ausgelöst ist, eines ersten Überschreitens einer vorbestimmten minimalen Spannungsschwelle durch die Einschwingspannung, wobei die Zeitdauer im Wesentlichen gleich zur maximalen Zeitdauer der Einschwingspannung ist, und Mittel (72) zum Vergleichen, während der Zeitdauer, des Vorzeichens des Einschwingstroms mit dem Vorzeichen der Einschwingspannung, umfasst.

4. Vorrichtung nach Anspruch 3,
**gekennzeichnet durch** eine erste Schaltungskette (62) zur Verarbeitung des gleichpoligen Stroms umfasst, mit einer ersten Stufe (66) zur Filterung und Verstärkung des gleichpoligen Stroms (I_{T}), deren Ausgang verbunden ist mit dem Eingang einer ersten Vergleicherstufe (68) zum Erfassen des ersten Überschreitens der Stromschwelle und des Vorzeichens dieses Überschreitens, wobei deren Ausgang mit einer Recheneinheit(72) verbunden ist.

5. Vorrichtung nach Anspruch 4,
**dadurch gekennzeichnet, dass** sie außerdem eine zweite Schaltungskette (64) zur Verarbeitung der gleichpoligen Spannung umfasst, die parallel zur ersten Schaltungskette (62) zur Verarbeitung des gleichpoligen Stroms arbeitet und eine zweite Stufe (74) zur Filterung und zur Verstärkung der gleichpoligen Spannung umfasst, deren Ausgang verbunden ist mit dem Eingang einer zweiten Vergleicherstufe (76) zum Erfassen des ersten Überschreitens der Spannungsschwelle und des Vorzeichens dieses Überschreitens, wobei deren Ausgang mit der Recheneinheit(72) verbunden ist.

6. Vorrichtung nach Anspruch 5,
**dadurch gekennzeichnet, dass** die Recheneinheit (72) während der Zeitdauer der Einschwingspannung das Vorzeichen des ersten Überschreitens der Stromschwelle durch den Einschwingstrom mit dem Vorzeichen des ersten Überschreitens der Spannungsschwelle durch die Einschwingspannung vergleicht und die Richtung des Fehlers auf der Leitung des elektrischen Energieverteilungsnetzes bestimmt.

## Claims

1. Method for detecting a fault on a line of an electric power distribution network, based on comparing the respective signs of the transient variations in the homopolar currents and of the transient variations in the homopolar voltages of the line to be monitored, **characterized in that** the first overrun by the current transient of a predetermined minimum current threshold is detected, the said overrun triggers a delay of a predetermined duration during which the first overrun by the voltage transient of a predetermined minimum voltage threshold is observed, the said duration being approximately equal to the maximum duration of the said voltage transient, and then, during this period, the sign of the current transient is compared with the sign of the voltage transient.

2. Method according to Claim 1, **characterized in that**, outside the said period of observation, the level of the homopolar voltage is blocked at a zero value so as to observe the variation in the voltage transient relative to a noise-free reference level.

3. Electronic device for detecting a fault on a line of an electrical power distribution network, on the basis of a comparison between the respective signs of transient homopolar current variations and transient homopolar voltage variations of the line to be monitored, **characterized in that** it comprises means (68) for detecting a first overrun by the current transient of a predetermined minimum current threshold, means for triggering, after the first overrun has been detected, a delay of a predetermined duration, means (76) for detecting, when the delay is triggered, a first overrun by the voltage transient of a predetermined minimum voltage threshold, the said duration being approximately equal to the maximum duration of the said voltage transient, and means (72) for comparing, during the said period, the sign of the current transient with the sign of the voltage transient.

4. Device according to Claim 3, **characterized in that** it includes a first chain (62) for processing the homopolar current, which comprises a first stage (66) for filtering and amplifying the homopolar current (IT), the output of which stage is connected to the input of a first comparator stage (68), intended to detect the first overrun of the current threshold and the sign of this overrun, and the output of which stage (68) is connected to a calculation block (72).

5. Device according to Claim 4, **characterized in that** it furthermore includes a second chain (64) for processing the homopolar voltage, which chain operates in parallel with the first chain (62) for processing the homopolar current and comprises a second stage (74) for filtering and amplifying the homopolar voltage, the output of which stage is connected to the input of a second comparator stage (76), intended to detect the first overrun of the voltage threshold and the sign of this overrun, and the output of which stage (76) is connected to the calculation block (72).

6. Device according to Claim 5, **characterized in that** the calculation block (72) compares, during the period of the voltage transient, the sign of the first overrun of the current threshold by the current transient with the sign of the first overrun of the voltage threshold by the voltage transient, and determines the direction of the fault on the line of an electrical power distribution network.
